# EUROPEAN PATENT APPLICATION

(11) **EP 1 566 828 A2**
(43) Date of publication of application: **24.08.2005**
(21) Application number: 05250864.5
(22) Date of filing: 15.02.2005
(51) Int. Cl.: H01J 49/02

(54) **Mass spectrometer**

(30) Priority: 18.02.2004 GB 0403533
(71) Applicant: Hoffman, Andrew, Manchester M20 2QT (GB); Clare, Mathew, Cheshire CW10 ORE (GB)
(72) Inventor: Hoffman, Andrew, Manchester M20 2QT (GB); Clare, Mathew, Cheshire CW10 ORE (GB)
(74) Representative: Wilson Gunn

(57) **Abstract**

A time of flight mass spectrometer has components mounted within an open ended box 10 formed from printed circuit boards (PCBs). The mass spectrometer comprises an ion source 20, an ion focussing means 30, an ion accelerating means 40, a detection chamber 50, an ion mirror 60 and an ion detector 70. Also there is provided a space 82 for a vacuum pump 80, the vacuum pump pumps air out of the PCB box 10 via aperture 84. The mass spectrometer further comprises an aluminium plate (not shown) is provided on which the PCB box 10 is mounted in use. The aluminium plate has a groove in which an O-ring is retained, the O-ring adapted to provide a seal between the plate and rim 13 of the PCB box 10. The plate is further provided with an air outlet for the vacuum pump 80 mounted in the PCB box 10. The vacuum pump 80 thus acts to draw air from the interior of the PCB box 10 through aperture 84 in to the pump and then expels said air through the air outlet in the plate to the exterior of the PCB box 10. As the PCBs themselves are impervious to air and the solder or glue seals between them are airtight, this allows a vacuum to be created within the PCB box 10 once a seal is formed between the plate and the rim 13.

## Description

The present invention relates to mass spectrometers and in particular to time of flight mass spectrometers.

In a conventional time of flight mass spectrometer an ion source, produces ions for analysis. On emergence from the ion source the ions have a velocity in a first direction and are focused into a beam by suitable ion lenses. The ions then pass between a pair of electrodes to which an impulse voltage is applied. This causes the acceleration of the ions in a second direction towards a detector through a measurement chamber. The detector detects the arrival of ions with larger charge to mass ratios before it detects the arrival of ions with lower charge to mass ratios because ions with a larger charge to mass ratio are accelerated to a greater velocity in the second direction by a given electric impulse from the electrodes. In some time of flight mass spectrometers the ions do not travel directly to the detector from the electrodes but are directed towards the detector by reflection from an ion mirror.

In order to allow the ions to travel unimpeded, the ions exit the ion source and travel to the detector through a vacuum. To achieve this in a typical mass spectrometer the ion source, ion lenses, electrodes, ion mirror detector and much of the associated electronics are mounted within a vacuum chamber. As it is desirable that the output of the detector is available during use and as it is also desirable that adjustments can to be made to the operating parameters in real time it is necessary to provide electrical connections between external circuitry and the components within the vacuum chamber. Providing connections through the walls of the vacuum chamber can be troublesome and adds to the complexity and hence cost of a typical mass spectrometer.

It is also the case that mounting the components of the mass spectrometer within a casing in this manner increases the weight and bulk of such devices. This further increases the cost of conventional mass spectrometers.

An additional problem with mounting a mass spectrometer within a bulky vacuum chamber is that routine adjustments or maintenance or rapid correction of faults is complicated by the necessity to open the vacuum chamber and remove the components mounted therein.

It is therefore an object of the present invention to provide a mass spectrometer which is adapted to alleviate the above problems.

According to the present invention there is provided a mass spectrometer comprising at least the following components: an ion source to provide ions for analysis; means for focusing ions provided by the ion source; means for accelerating ions provided by the ion source; and a detector for detecting said ions wherein said ions provided by said ion source travel through a vacuum to said detector characterised in that one or more printed circuit boards (PCBs) on which said components are mounted and which provide electrical connections to and from the components to are adapted to form walls of a vacuum chamber.

In this manner the invention provides a low cost light weight vacuum chamber for a mass spectrometer, which if electrical connections are provided between the faces of said one or more PCBs allows easy electronic connection to the various components of the mass spectrometer.

Preferably, if PCBs are adapted to form adjacent walls or adjacent sections of walls, said PCBs are joined to one another by solder, glue or any other suitable means. In a preferred embodiment, a plurality of PCBs are joined together to form an open ended box. A suitable plate may be provided for placing across the end of the box to provide a releasable seal when necessary. To facilitate a better seal between the plate and the PCB box, additional sections of PCB or other suitable material may be joined to the box in such a manner as to form a rim around the open end of the box. Preferably an O-ring is placed between the PCB box and the plate; and the PCB box and the plate are then releasably clamped or otherwise forced together to form and maintain the seal therebetween.

The O-ring is preferably adapted to be retained in a groove provided on the plate. In this manner the O-ring can be prevented from sliding laterally relative to the PCB box and plate, thus improving the seal formed therebetween.

The plate is preferably adapted to provide an outlet for a vacuum pump used to create a vacuum within the sealed chamber formed by the box and plate. The plate may be formed from any suitable material however, in a preferred embodiment the plate is formed from aluminium.

In one embodiment the box and plate may be joined via a hinge. This facilitates both correct relative placement during sealing and easy access to components within the spectrometer when desired.

Any suitable ion source may be used in the present invention, said ion source may be adapted to form ions utilising any suitable means of ionisation, as desired or appropriate, including but not limited to; electron impact, chemical ionisation; thermo or electro spray ionisation, fast ion bombardment; or any other suitable means of ionisation. The ion source may be adapted to generate either a continuous beam or a pulsed beam of ions as desired or appropriate.

Preferably, the ions emitted by the ion source are focussed by one or more ion lenses. Most preferably, the ion lens or lenses may be slid into releasable mountings. Preferably, a plurality of such mountings are provided along the path of the ions emitted from the ion source. This allows the ion lenses to be readily swapped for alternative lenses or moved to an alternative housing to ensure that ions emitted from the ion source are focussed as desired.

Preferably, the means for accelerating ions is an arrangement of electrodes such as those used in conventional time of flight mass spectrometers. The detector for detecting ions may be any suitable detector used in time of flight mass spectrometers. In some embodiments an ion mirror may be provided to reflect accelerated ions towards the detector. This provides a longer path length between the acceleration and the detection of ions and thus enables a greater resolution of different charge to mass ratios.

Preferably some control electronics and or some control switches may also be provided on the PCBs if desired. Most preferably said switches are provided on the exterior side of the PCBs, thereby allowing an operator to access them during use. Preferably the PCBs used are sufficiently thick to support a vacuum within the chamber.

In order that the invention is more clearly understood, it will now be described further herein, with reference to the accompanying drawings in which:
Figure 1 is a cutaway view from above of a mass spectrometer according to the present invention;
Figure 2 is a cutaway view from below of a mass spectrometer according to the present invention;
Figure 3 is a view of an ion source for use in a mass spectrometer according to the present invention;
Figure 4 shows how the ion source of figure 3 may be mounted in a mass spectrometer according to the present invention;
Figure 5 shows how ion lenses may be mounted or remounted in a mass spectrometer according to the present invention;
Figure 6 is a view of the detection chamber through which accelerated ions travel to a detector illustrating how the detection chamber is mounted in a mass spectrometer according to the present invention;
Figure 7 is another view of the detection chamber of figure 6; and
Figure 8 shows how a detector may be mounted in a mass spectrometer according to the present invention.

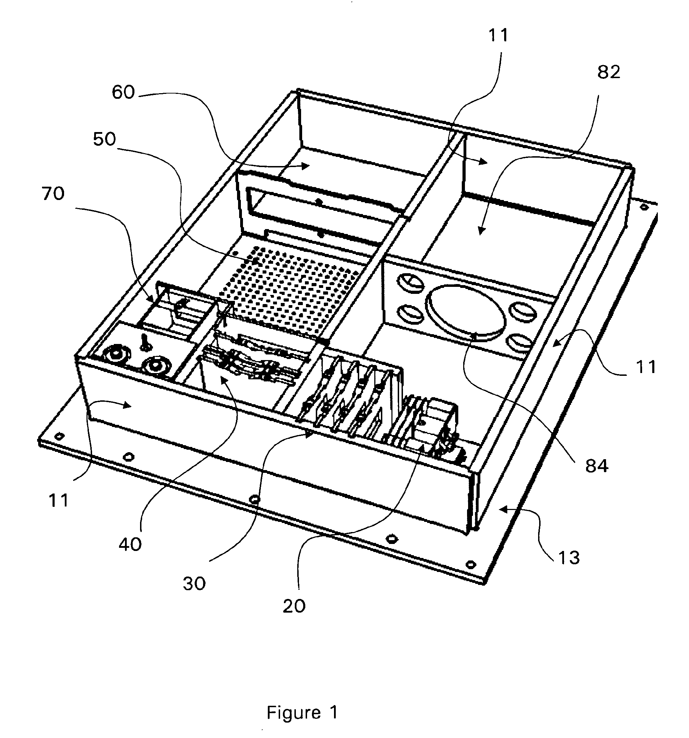

Referring now to figure 1, a time of flight mass spectrometer has components mounted within an open ended box 10 formed from printed circuit boards (PCBs). The mass spectrometer comprises an ion source 20, an ion focussing means 30, an ion accelerating means 40, a detection chamber 50, an ion mirror 60 and an ion detector 70. Also shown in figure 1 is a space 82 for a vacuum pump 80, the vacuum pump pumps air out of the PCB box 10 via aperture 84.

In use, matter is fed into the ion source 20 wherein it is formed into a beam of ions for analysis. This ion beam is focussed by the ion focussing means 30 and then passes into ion accelerating means 40 which applies a large impulse voltage to the ion beam. As a result of the large impulse voltage ions are accelerated through time of flight chamber 50 towards ion mirror 60. Ions which impact on ion mirror 60 are reflected and travel towards detector 70 wherein their arrival is detected and a corresponding output signal is generated. By monitoring the time taken for ions to arrive at the detector 70 after being accelerated, the charge to mass ratio of the ions can be determined.

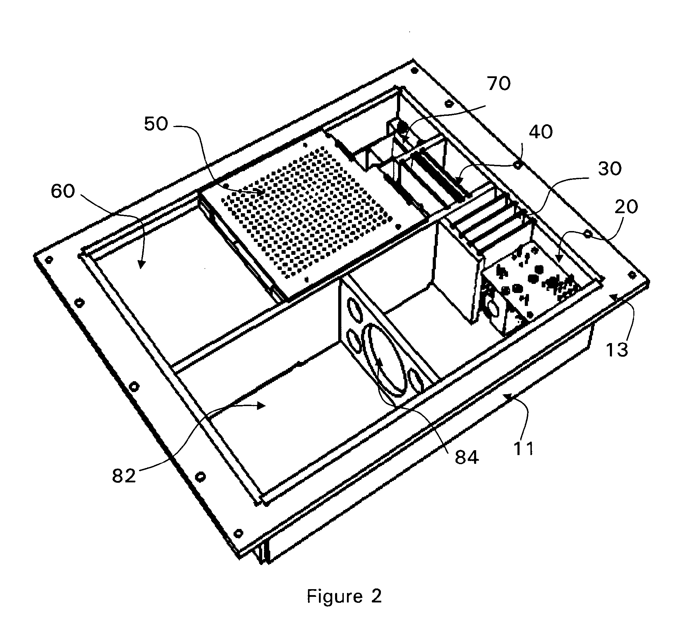

The various components 20-70 are mounted on PCBs forming the open-ended box 10 within which all the components sit. The box 10 comprises four sidewalls 11, a rim 13 and a top (not shown), the top being provided over the opposite ends of the side walls 11 to the rim 13 all formed of PCBs. The individual PCBs are joined by solder, glue or by any other suitable means so as to provide airtight joins. Figure 1 shows the components 20-70 mounted within the PCB box from above and figure 2 shows the components 20-70 mounted within the PCB box from below.

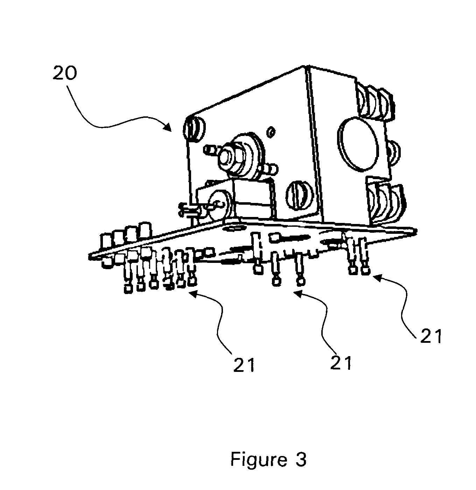

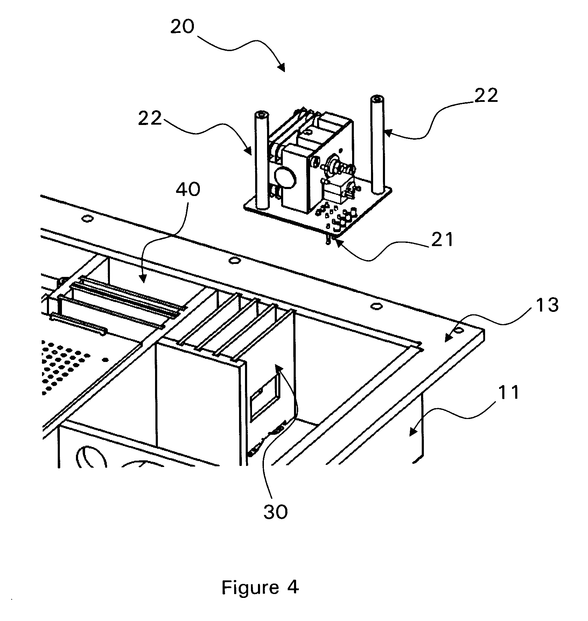

Figure 3 shows a view of the ion source 20. Pins 21 provide electrical connections between the ion source 20 and the PCB on which it is mounted, in this case this is the top. Figure 4 shows how the ion source 20 is mounted in the PCB box. Struts 22 are provided to secure the ion source 20 in position.

The ion source 20 is of conventional form and may form ions utilising any suitable means of ionisation as desired or appropriate. For example, the ion source 20 may use electron impact, chemical ionisation, thermo or electro spray ionisation, fast ion bombardment or any other suitable means of ionisation. The ion source 20 can generate either a continuous beam or a pulsed beam of ions as desired or appropriate.

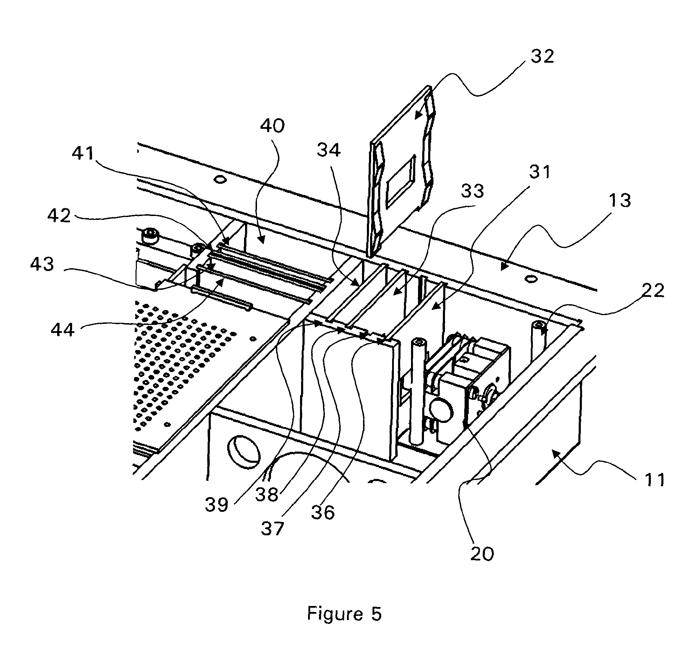

In figure 5 shows the ion focussing means 30 and the ion accelerating means 40 in greater detail. The ion focussing means comprises four ion mirrors 31-34 which can be mounted in any one of four pairs of retaining slots 36-39. Each lens 31-34 may have identical or different focussing power to the other lenses and may be placed in anyone of the four pairs of slots 36-39. The particular focussing power of the lenses used and their relative positions can be varied, as required or as desired, to provide a suitable ion beam.

It is envisaged that a plurality of alternative ion lenses may be kept by a user for substitution into the focussing means, when necessary or desired. In particular, the lens arrangement may be varied if the mass of the ions for analysis varies. In alternative embodiments, more than or less than four slots may be provided for holding ion lenses, if desired.

The ion accelerating means 40 in this embodiment comprises four electrodes 41-44. The electrodes 41-44 are adapted to allow the application of a large impulse voltage for the purpose of accelerating ions provided by the ion source 20 into the chamber 50.

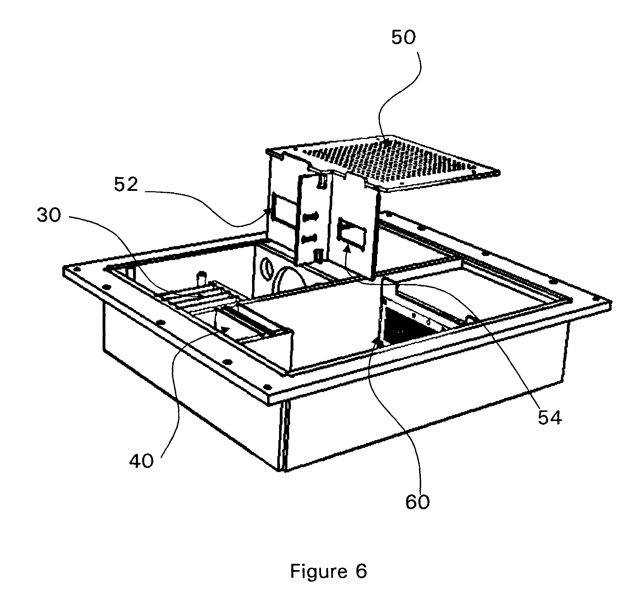

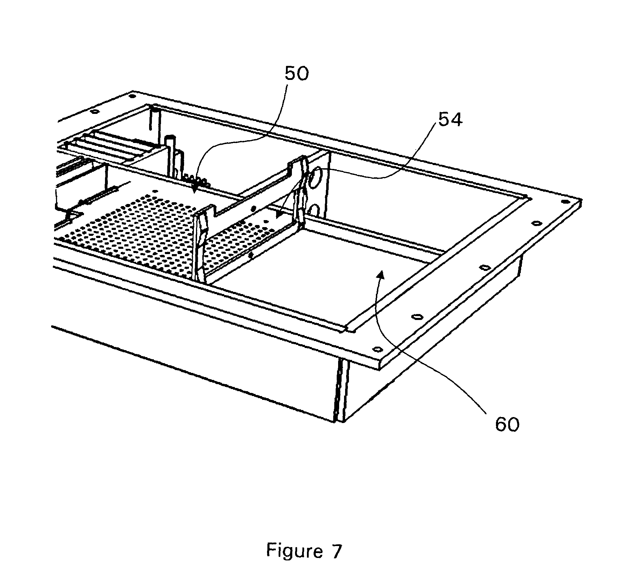

Figure 6 & 7 show the time of flight chamber 50 in greater detail than the previous drawings. Visible on these images are the entry aperture 52 which allows accelerated ions to enter the chamber 50, the reflection aperture 54 which allows ions to exit the chamber 50 reflect from the ion mirror 60 and re-enter the chamber 50 and the exit aperture 56 which allows ions to exit the chamber 50 and enter the detector 70. It is of course possible to omit the ion mirror 60 if desired and provide a mass spectrometer wherein accelerated ions travel directly from the acceleration means 40 to the detector 70.

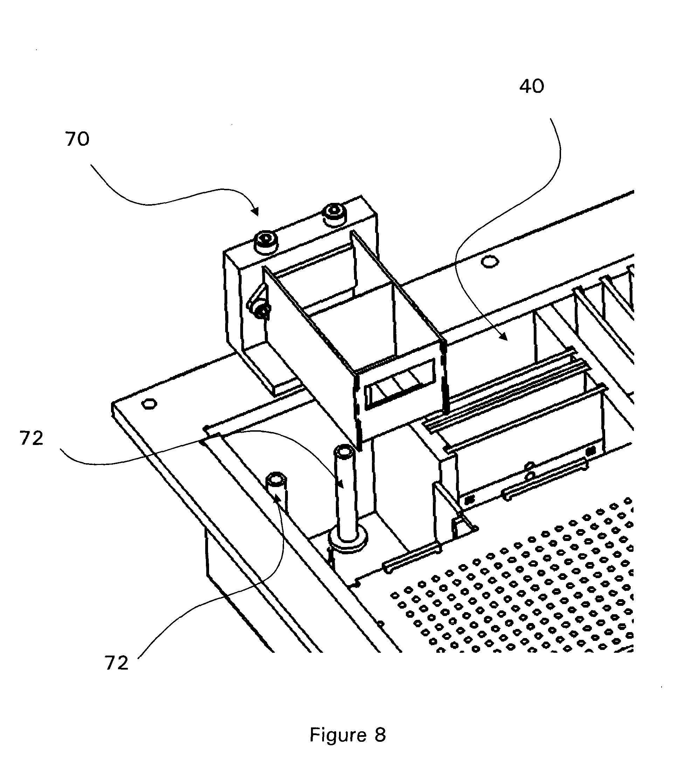

Figure 8 shows, from below, insertion of the detector 70 into the mass spectrometer. Posts 72 are provided on which the detector 70 may be securely mounted. Additional electrical contacts between the detector and PCB 12 are provided allowing the output of the detector to be viewed and or processed by external circuitry.

The mass spectrometer further comprises an aluminium plate (not shown), on which the PCB box 10 is mounted in use. The aluminium plate has a groove in which an O-ring is retained, the O-ring adapted to provide a seal between the plate and rim 13 of the PCB box 10. In order that the seal be securely formed clamping means or similar may be provided to retain the PCB box 10 in position relative to the plate.

The plate is further provided with an air outlet for the vacuum pump 80 mounted in the PCB box 10. The vacuum pump 80 thus acts to draw air from the interior of the PCB box 10 through aperture 84 in to the pump 80 and then expels said air through the air outlet in the plate to the exterior of the PCB box 10. As the PCBs themselves are impervious to air and the solder or glue seals between them are airtight, this allows a vacuum to be created within the PCB box 10 once a seal is formed between the plate and the rim 13.

As the PCBs forming the box 10 provide the electrical connections to each component, a secure mount for each component and the outer walls of a vacuum chamber the mass spectrometer is smaller and lighter than conventional mass spectrometers. This also has the benefit that the mass spectrometer can be made more cheaply than a conventional mass spectrometer. The smaller size and ready access to electrical connections to the components make this mass spectrometer more convenient to use than a conventional mass spectrometer.

It is of course to be understood that the invention is not to be limited to the details of the above embodiments which are described by way of example only.

## Claims

1. A mass spectrometer comprising at least the following components: an ion source to provide ions for analysis; means for focusing ions provided by the ion source; means for accelerating ions provided by the ion source; and a detector for detecting said ions wherein said ions provided by said ion source travel through a vacuum to said detector **characterised in that** one or more printed circuit boards (PCBs) on which said components are mounted and which provide electrical connections to and from the components to are adapted to form walls of a vacuum chamber.

2. A mass spectrometer as claimed in claim 1 wherein if PCBs are adapted to form adjacent walls or adjacent sections of walls, said PCBs are joined to one another by solder or glue.

3. A mass spectrometer as claimed in claim 1 or claim 2 wherein a plurality of PCBs are joined together to form an open ended box.

4. A mass spectrometer as claimed in claim 3 wherein a plate is provided for placing across the end of the box to provide a releasable seal.

5. A mass spectrometer as claimed in claim 4 wherein additional sections of PCB are joined to the box so as to form a rim around the open end of the box.

6. A mass spectrometer as claimed in claim 5 wherein an O-ring is placed between the PCB box and the plate; and the PCB box and the plate are then releasably clamped, the O-ring being adapted to be retained in a groove provided on the plate.

7. A mass spectrometer as claimed in any one of claims 4 to 6 wherein the plate is adapted to provide an outlet for a vacuum pump.

8. A mass spectrometer as claimed in any one of claims 4 to 7 wherein the plate is formed from aluminium.

9. A mass spectrometer as claimed in any one of claims 4 to 8 wherein the box and plate are joined via a hinge.

10. A mass spectrometer as claimed in any preceding claim wherein said ion source is adapted to form ions utilising any one of the following means of ionisation: electron impact; chemical ionisation; thermo or electro spray ionisation; and fast ion bombardment.

11. A mass spectrometer as claimed in any preceding claim wherein the ion source is adapted to generate either a continuous beam of ions or a pulsed beam of ions.

12. A mass spectrometer as claimed in any preceding claim wherein the ions emitted by the ion source are focussed by one or more ion lenses slid into releasable mountings provided along the path of the ions emitted from the ion source.

13. A mass spectrometer as claimed in any preceding claim wherein control electronics and or control switches are provided on the PCBs.

14. A mass spectrometer as claimed in claim 13 wherein said switches are provided on the exterior side of the PCBs.
